# EUROPEAN PATENT APPLICATION

(11) **EP 4 621 825 A2**
(43) Date of publication of application: **24.09.2025**
(21) Application number: 25162131.4
(22) Date of filing: 06.03.2025
(51) Int. Cl.: H01J 37/18, H01J 37/16, H01J 37/20, H01J 37/26

(54) **CHARGED PARTICLE BEAM SYSTEM AND METHOD OF CONTROLLING CHARGED PARTICLE BEAM SYSTEM**

(30) Priority: 21.03.2024 JP 2024044693
(71) Applicant: Jeol Ltd., Akishima-shi, Tokyo 196-8558 (JP)
(72) Inventor: MATSUZAKI, Mizuki, Tokyo, 196-8558 (JP); FUJIMOTO, Naoki, Tokyo, 196-8558 (JP); ARIMA, Norikazu, Tokyo, 196-8558 (JP); IKEDA, Yuta, Tokyo, 196-8558 (JP)
(74) Representative: Boult Wade Tennant LLP

(57) **Abstract**

A charged particle beam system includes: a sample chamber (202); a pre-evacuation chamber (232) that is connected to the sample chamber (202); a first evacuation pump (510) that has a first port (512) connected to the sample chamber (202), and a second port (514) connected to the pre-evacuation chamber (232); a second evacuation pump (520) that is connected to the pre-evacuation chamber (232), an evacuation port (516), and the sample chamber (202); and a controller (400) that controls the first evacuation pump (510) and the second evacuation pump (520), the controller (400) performing, when a sample (S) is introduced into the pre-evacuation chamber (232): a process of causing the second evacuation pump (520) to evacuate the pre-evacuation chamber (232); a process of making a determination of whether a vacuum degree inside the pre-evacuation chamber (232) has reached a first vacuum degree, based on power of the second evacuation pump (520); and a process of causing the first evacuation pump (510) to evacuate the pre-evacuation chamber (232) when the vacuum degree inside the pre-evacuation chamber (232) is determined to have reached the first vacuum degree.

## Description

### BACKGROUND OF THE INVENTION

### Field of the Invention

The present invention relates to a charged particle beam system and a method of controlling a charged particle beam system.

### Description of Related Art

In charged particle beam systems such as transmission electron microscopes, scanning electron microscopes, and focused ion beam systems, pre-evacuation is performed to prevent a reduction in the vacuum degree inside a sample chamber when introducing a sample into the sample chamber.

For example, in JP 2021-118056 A, a sample is introduced into a pre-evacuation chamber, and then the pre-evacuation chamber is evacuated by a rough evacuation pump. After confirming that the vacuum degree inside the pre-evacuation chamber has reached a degree higher than a desired vacuum degree, a partition valve isolating the pre-evacuation chamber and a sample chamber is opened to introduce the sample into the sample chamber.

In such charged particle beam systems, it is desirable that a sample be introduced from a pre-evacuation chamber into a sample chamber without reducing the vacuum degree inside the sample chamber.

### SUMMARY OF THE INVENTION

According to a first aspect of the present disclosure, there is provided a charged particle beam system illuminating a sample with a charged particle beam, the charged particle beam system including:
a sample chamber in which a sample is placed;
a pre-evacuation chamber that is connected to the sample chamber via a partition valve;
a first evacuation pump that has a first port, a second port, and an evacuation port, the first port being connected to the sample chamber, and the second port being connected to the pre-evacuation chamber;
a second evacuation pump that is connected to the pre-evacuation chamber, the evacuation port, and the sample chamber; and
a controller that controls the first evacuation pump and the second evacuation pump,
the controller performing, when a sample is introduced into the pre-evacuation chamber:
   a process of causing the second evacuation pump to evacuate the pre-evacuation chamber;
   a process of making a determination of whether a vacuum degree inside the pre-evacuation chamber has reached a first vacuum degree, based on power of the second evacuation pump; and
   a process of causing the first evacuation pump to evacuate the pre-evacuation chamber when the vacuum degree inside the pre-evacuation chamber is determined to have reached the first vacuum degree.

According to a second aspect of the present disclosure, there is provided a method of controlling a charged particle beam system that includes
a sample chamber in which a sample is placed,
a pre-evacuation chamber that is connected to the sample chamber via a partition valve,
a first evacuation pump that has a first port, a second port, and an evacuation port, the first port being connected to the sample chamber, and the second port being connected to the pre-evacuation chamber, and
a second evacuation pump that is connected to the pre-evacuation chamber, the evacuation port, and the sample chamber,
the method comprising:
   causing the second evacuation pump to evacuate the pre-evacuation chamber when a sample is introduced into the pre-evacuation chamber;
   determining whether a vacuum degree inside the pre-evacuation chamber has reached a first vacuum degree, based on power of the second evacuation pump; and
   causing the first evacuation pump to evacuate the pre-evacuation chamber when the vacuum degree inside the pre-evacuation chamber is determined to have reached the first vacuum degree.

### BRIEF DESCRIPTION OF THE DRAWINGS

FIG. 1 is a diagram illustrating an example of a configuration of a transmission electron microscope according to the first embodiment.
FIG. 2 is a perspective view schematically illustrating a housing.
FIG. 3 is a front elevation schematically illustrating a housing.
FIG. 4 is a diagram illustrating an example of a configuration of a vacuum pumping system.
FIG. 5 is a flowchart illustrating an example of a control process of a vacuum pumping system during evacuation of a sample chamber.
FIG. 6 is a flowchart illustrating an example of a control process of a vacuum pumping system during introduction of a sample into a sample chamber.
FIG. 7 is a flowchart illustrating an example of a control process of a vacuum pumping system during examination.
FIG. 8 is a flowchart illustrating a modified example of a control process of a vacuum pumping system during examination.
FIG. 9 is a flowchart illustrating an example of a control process of a vacuum pumping system during non-examination.
FIG. 10 is a diagram schematically illustrating a graphical user interface (GUI) screen.
FIG. 11 is a diagram schematically illustrating a GUI screen.
FIG. 12 is a diagram illustrating a modified example of a configuration of a vacuum pumping system.
FIG. 13 is a flowchart illustrating an example of a control process of a vacuum pumping system during non-examination.
FIG. 14 is a diagram illustrating a modified example of a configuration of a vacuum pumping system.

### DESCRIPTION OF THE INVENTION

According to an embodiment of the present disclosure, there is provided a charged particle beam system that illuminates a sample with a charged particle beam, the charged particle beam system including:
a sample chamber in which a sample is placed;
a pre-evacuation chamber that is connected to the sample chamber via a partition valve;
a first evacuation pump that has a first port, a second port, and an evacuation port, the first port being connected to the sample chamber, and the second port being connected to the pre-evacuation chamber;
a second evacuation pump that is connected to the pre-evacuation chamber, the evacuation port, and the sample chamber; and
a controller that controls the first evacuation pump and the second evacuation pump,
the controller performing, when a sample is introduced into the pre-evacuation chamber:
   a process of causing the second evacuation pump to evacuate the pre-evacuation chamber;
   a process of making a determination of whether a vacuum degree inside the pre-evacuation chamber has reached a first vacuum degree, based on power of the second evacuation pump; and
   a process of causing the first evacuation pump to evacuate the pre-evacuation chamber when the vacuum degree inside the pre-evacuation chamber is determined to have reached the first vacuum degree.

In the charged particle beam system described above, the pre-evacuation chamber is capable of being evacuated by the first evacuation pump. As a result, when introducing a sample from the pre-evacuation chamber into the sample chamber with the partition valve open, it is possible to reduce a reduction in the vacuum degree inside the sample chamber. Moreover, in the charged particle beam system, the vacuum degree inside the pre-evacuation chamber is determined from the power of the second evacuation pump. Therefore, a vacuum gauge to measure the vacuum degree inside the pre-evacuation chamber is not required. Accordingly, it is possible to reduce the number of components in the charged particle beam system.

According to an embodiment of the present disclosure, there is provided a method of controlling a charged particle beam system that includes
a sample chamber in which a sample is placed,
a pre-evacuation chamber that is connected to the sample chamber via a partition valve,
a first evacuation pump that has a first port, a second port, and an evacuation port, the first port being connected to the sample chamber, and the second port being connected to the pre-evacuation chamber, and
a second evacuation pump that is connected to the pre-evacuation chamber, the evacuation port, and the sample chamber,
the method comprising:
   causing the second evacuation pump to evacuate the pre-evacuation chamber when a sample is introduced into the pre-evacuation chamber;
   determining whether a vacuum degree inside the pre-evacuation chamber has reached a first vacuum degree, based on power of the second evacuation pump; and
   causing the first evacuation pump to evacuate the pre-evacuation chamber when the vacuum degree inside the pre-evacuation chamber is determined to have reached the first vacuum degree.

In the control method for the charged particle beam system described above, the pre-evacuation chamber is evacuated by the first evacuation pump. As a result, when introducing a sample from the pre-evacuation chamber into the sample chamber with the partition valve open, it is possible to reduce a reduction in the vacuum degree inside the sample chamber. Moreover, in the control method for the charged particle beam system, the vacuum degree inside the pre-evacuation chamber is determined from the power of the second evacuation pump. Therefore, a vacuum gauge to measure the vacuum degree inside the pre-evacuation chamber is not required. Accordingly, it is possible to reduce the number of components in the control method for the charged particle beam system.

Preferred embodiments of the invention will be described in detail below with reference to the drawings. It is noted that the embodiments described below are not unduly limit the contents of the invention described in the claims. Further, all of the components described below are not necessarily essential requirements of the invention.

Furthermore, the following description will illustrate the case where the charged particle beam system according to the invention is a transmission electron microscope that illuminates a sample with an electron beam. However, the charged particle beam system according to the invention may also be a device that illuminates a sample with a charged particle beam (such as an ion beam) other than an electron beam.

### 1. First Embodiment

### 1.1. Transmission Electron Microscope

### 1.1.1. Configuration of Transmission Electron Microscope

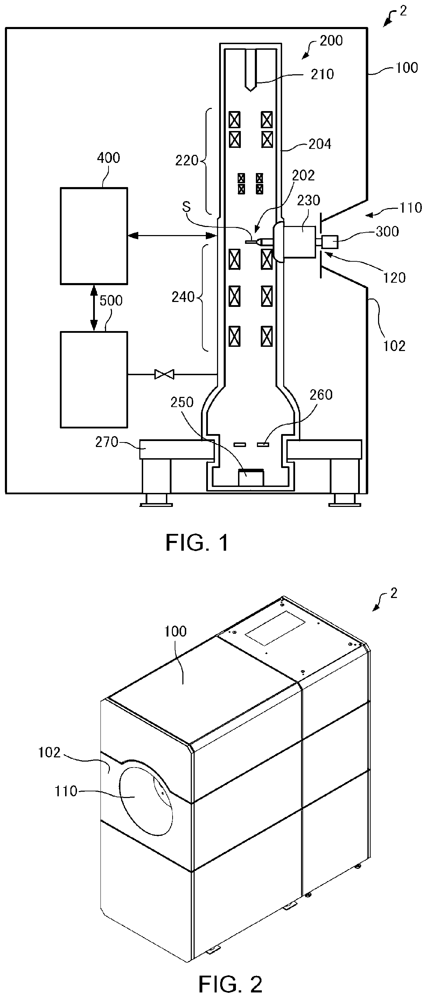

First, a transmission electron microscope according to the first embodiment will be described with reference to the drawings. FIG. 1 is a diagram illustrating an example of a configuration of a transmission electron microscope 2 according to the first embodiment of the invention.

As illustrated in FIG. 1, the transmission electron microscope 2 includes a housing 100, a body portion 200, a sample holder 300, a controller 400, and a vacuum pumping system 500.

The housing 100 accommodates the body portion 200, the controller 400, and the vacuum pumping system 500 of the transmission electron microscope 2.

The body portion 200 includes: an electron gun 210; an illumination optical system 220 that illuminates a sample S with electrons emitted from the electron gun 210; a holder support portion 230 with an insertion port that enables the insertion and extraction of the sample holder 300; an imaging optical system 240 that forms an image with the electrons that have passed through the sample S; an imager 250 that captures a transmission electron microscope image (TEM image) formed with the electrons that have passed through the sample S, and a detector 260 that obtains a scanning transmission electron microscope image (STEM image) by detecting the electrons that have passed through the sample S. The illumination optical system 220 and the imaging optical system 240 are accommodated in an electron optical column 204. Inside the electron optical column 204 including a sample chamber 202, a vacuum state is maintained. The body portion 200 is supported by a vibration isolating table 270.

In the body portion 200, the illumination optical system 220 focuses an electron beam to form an electron probe and deflects the electron beam. This enables scanning the sample S with the electron probe. In the transmission electron microscope 2, the detector 260 detects the electrons that have passed through the sample S while the sample S is scanned by the electron probe, enabling the acquisition of an STEM image. Furthermore, in the transmission electron microscope 2, the illumination optical system 220 illuminates the sample S with an electron beam in parallel, the imaging optical system 240 forms a TEM image using the electrons that have passed through the sample S, and the imager 250 captures the TEM image.

Note that the configuration of the body portion 200 is not particularly limited and may include, for example, various detectors, various spectrometers, various manipulators, and the like. For example, the body portion 200 may include an X-ray detector that detects a characteristic X-ray emitted from the sample S by illuminating the sample S with an electron beam.

The body portion 200 has the sample chamber 202 where the sample S is placed. The sample S placed in the sample chamber 202 is supported by the sample holder 300. The sample holder 300 is inserted into the insertion port of the holder support portion 230. The sample holder 300 is designed to enable its insertion into and extraction from the insertion port of the holder support portion 230.

The controller 400 controls each component of the transmission electron microscope 2. The controller 400 includes, for example, a processor such as a central processing unit (CPU) and a storage device composed of a random access memory (RAM), a read-only memory (ROM), and the like. The storage device stores programs and data to perform various control operations. The function of the controller 400 is implemented by executing a program on a processor. Note that the controller 400 may be implemented, for example, as a general-purpose circuit such as a microcontroller or a microprocessor that operates according to a program, or as a dedicated circuit such as an application-specific integrated circuit (ASIC).

The vacuum pumping system 500 vacuum-evacuates an electron gun chamber that is the space where the electron gun 210 is accommodated, the space inside the electron optical column 204 including the sample chamber 202, the space where the imager 250 or the detector 260 is placed, and the like. Furthermore, the vacuum pumping system 500 is also used for pre-evacuation when the sample holder 300 is introduced into the sample chamber 202. The vacuum pumping system 500 is controlled by the controller 400. Note that a computer and the vacuum pumping system 500 functioning as the controller 400 may be positioned outside the housing 100.

### 1.1.2. Housing

FIG. 2 is a perspective view schematically illustrating the housing 100. As illustrated in FIG. 2, the housing 100 has a rectangular prism shape. The housing 100 includes a plurality of plates. The plates are metallic plates. The housing 100 covers the body portion 200 with the plurality of plates. Therefore, the body portion 200 is not visually recognizable from the outside of the housing 100. Note that the housing 100 may include a plurality of resinous plates and cover the body portion 200 with the resinous plates.

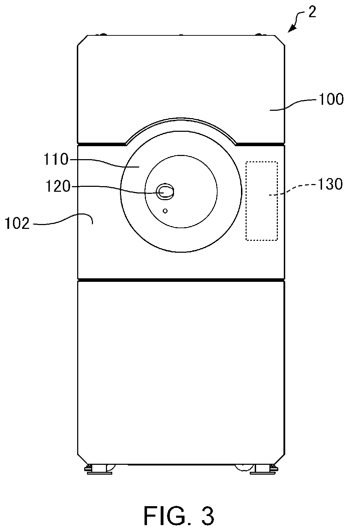

FIG. 3 is a front elevation schematically illustrating the housing 100.

As illustrated in FIGS. 2 and 3, the housing 100 has a recessed portion 110 formed thereon. The recessed portion 110 is provided on a side surface 102 of the housing 100. The side surface 102 is a surface that constitutes the front of the housing 100. At the bottom of the recessed portion 110, a replacement port 120 is formed. The replacement port 120 is an opening portion that enables the sample holder 300 to access the insertion port of the holder support portion 230.

The housing 100 includes an operation unit 130 that receives operations from the user. The operation unit 130 is provided on the side surface 102 of the housing 100. In other words, the operation unit 130 and the recessed portion 110 are provided on the same side surface 102. When the operation unit 130 receives an operation from the user, the controller 400 performs a process corresponding to the user's operation. The operation unit 130 is, for example, a touch panel.

### 1.1.3. Vacuum Pumping System

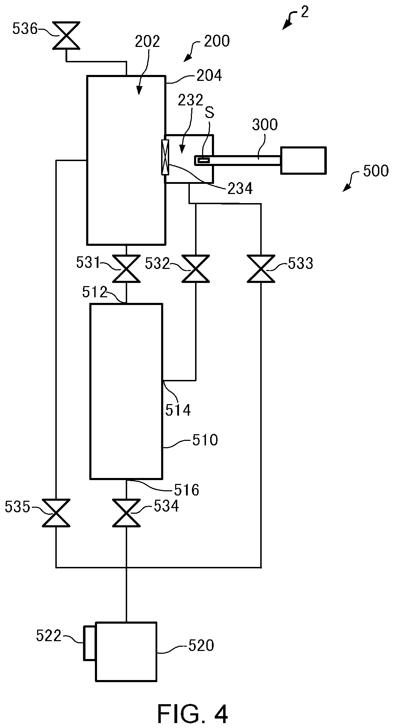

FIG. 4 is a diagram illustrating an example of the configuration of the vacuum pumping system 500.

As illustrated in FIG. 4, the vacuum pumping system 500 includes a main evacuation pump 510 (an example of a first evacuation pump), a sub-evacuation pump 520 (an example of a second evacuation pump), a temperature gauge 522, a first valve 531, a second valve 532, a third valve 533, a fourth valve 534, a fifth valve 535, and a leak valve 536.

The holder support portion 230 is provided with a pre-evacuation chamber 232. The pre-evacuation chamber 232 is connected to the sample chamber 202 via a partition valve 234. In other words, the pre-evacuation chamber 232 and the sample chamber 202 are isolated by the partition valve 234 and communicate with each other when the partition valve 234 is opened.

The main evacuation pump 510 is connected to the body portion 200 via a vibration-proof damper. Therefore, even when the main evacuation pump 510 operates, the impact on the body portion 200 is small. The main evacuation pump 510 has a first port 512, a second port 514, and an evacuation port 516. The first port 512 and the second port 514 are suction ports. The evacuation capacity obtained using the first port 512 is greater than that obtained using the second port 514. In other words, the first port 512 is a main port, and the second port 514 is a sub-port.

The main evacuation pump 510 is, for example, a turbo molecular pump. The turbo molecular pump is a pump that has a multiplicity of metallic blades obliquely attached to the periphery of a cylinder and is designed to compress and evacuate gas by rotating the cylinder at high speed. Between the first port 512 and the evacuation port 516, a multiplicity of metallic blades are arranged. The second port 514 is provided between the first port 512 and the evacuation port 516. In other words, the number of the metallic blades arranged between the first port 512 and the evacuation port 516 is greater than that arranged between the second port 514 and the evacuation port 516. Therefore, the evacuation capacity of the first port 512 is greater than that of the second port 514.

The first port 512 is connected to the sample chamber 202. Here, the electron gun chamber, the space inside the electron optical column 204 including the sample chamber 202, and the space where the imager 250 and the detector 260 are arranged are in communication with each other. In other words, in the transmission electron microscope 2, no orifice or the like, which maintains a pressure difference, is provided between these spaces, and the spaces form a single space with no pressure difference. Therefore, the evacuation of the single space is enabled through the first port 512.

The second port 514 is connected to the pre-evacuation chamber 232. The evacuation port 516 is connected to the sub-evacuation pump 520.

The sub-evacuation pump 520 is stored in a console connected to the body portion 200. Therefore, the transmission electron microscope 2 enables the miniaturization of the device. The transmission electron microscope 2 does not include a vibration isolation mechanism to prevent the vibrations of the sub-evacuation pump 520 from being transmitted to the body portion 200. Therefore, when the sub-evacuation pump 520 operates, the impact on the body portion 200 is significant.

The sub-evacuation pump 520 is, for example, a diaphragm pump. The diaphragm pump is a pump that evacuates fluid by varying the volume inside the pump chamber, which is isolated by a diaphragm, through the reciprocating motion of the diaphragm. The sub-evacuation pump 520 is connected to the pre-evacuation chamber 232, the evacuation port 516, and the sample chamber 202.

The main evacuation pump 510 functions as a primary pump to evacuate the sample chamber 202 and the pre-evacuation chamber 232 to the target vacuum degree and maintain the vacuum degree. The sub-evacuation pump 520 functions as a roughing pump that evacuates the sample chamber 202 and the pre-evacuation chamber 232 to the vacuum degree at which the main evacuation pump 510 is enabled to perform evacuation. Furthermore, the sub-evacuation pump 520 also functions as an auxiliary pump to maintain the backing pressure of the main evacuation pump 510 at a pressure less than or equal to the pressure at which the main evacuation pump 510 is enabled to function.

The temperature gauge 522 measures the temperature of the sub-evacuation pump 520. Information on the temperature of the sub-evacuation pump 520 measured by the temperature gauge 522 is transmitted to the controller 400.

The first valve 531 is provided between the first port 512 and the sample chamber 202. In other words, the first valve 531 is provided on an evacuation path that connects the first port 512 and the sample chamber 202.

The second valve 532 is provided between the second port 514 and the pre-evacuation chamber 232. In other words, the second valve 532 is provided on an evacuation path that connects the second port 514 and the pre-evacuation chamber 232.

The third valve 533 is provided between the sub-evacuation pump 520 and the pre-evacuation chamber 232. In other words, the third valve 533 is provided on an evacuation path that connects the sub-evacuation pump 520 and the pre-evacuation chamber 232.

The fourth valve 534 is provided between the sub-evacuation pump 520 and the evacuation port 516 of the main evacuation pump 510. In other words, the fourth valve 534 is provided on an evacuation path that connects the sub-evacuation pump 520 and the evacuation port 516.

The fifth valve 535 is provided between the sub-evacuation pump 520 and the sample chamber 202. In other words, the fifth valve 535 is provided on an evacuation path that connects the sub-evacuation pump 520 and the sample chamber 202.

The leak valve 536 is a valve that opens the sample chamber 202 to the atmosphere. In the transmission electron microscope 2, the space inside the electron optical column 204 including the electron gun chamber and the sample chamber 202 forms a single space as described above. Therefore, the leak valve 536 enables the single space to be opened to the atmosphere.

The controller 400 controls the main evacuation pump 510, the sub-evacuation pump 520, the first valve 531, the second valve 532, the third valve 533, the fourth valve 534, the fifth valve 535, and the leak valve 536. The controller 400 further controls the partition valve 234. The controller 400 monitors the power consumption of the main evacuation pump 510. Furthermore, the controller 400 monitors the power consumption of the sub-evacuation pump 520.

### 1.2. Operation

### 1.2.1. Operation of Vacuum Pumping System during Evacuation of Sample Chamber

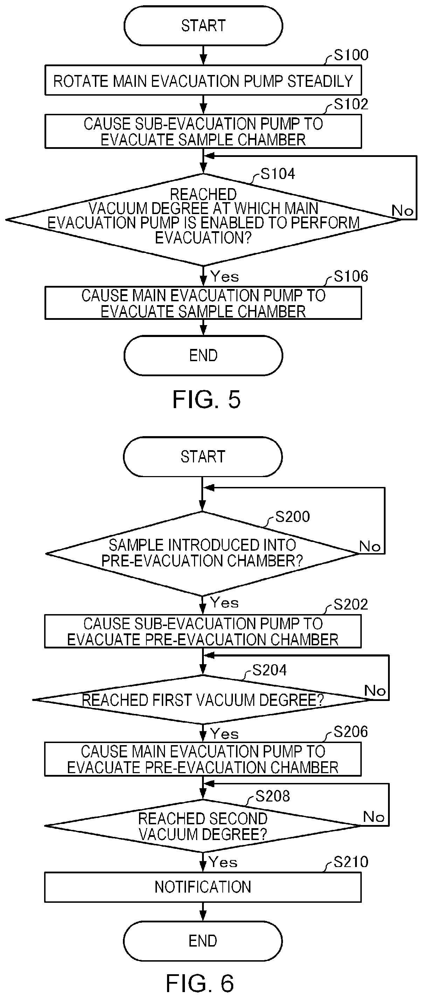

FIG. 5 is a flowchart illustrating an example of the control process of the vacuum pumping system 500 during the evacuation of the sample chamber 202. In an initial state, the sample chamber 202 is open to the atmosphere, and the partition valve 234 and the first to fifth valves are closed. The control process illustrated in FIG. 5 is a process for transitioning the state of the sample chamber 202 from being open to the atmosphere to a vacuum state where the sample S is capable of being introduced into the sample chamber 202.

First, the controller 400 rotates the main evacuation pump 510 steadily (step S100). The controller 400 operates the sub-evacuation pump 520 to open the fourth valve 534 and causes the sub-evacuation pump 520 to evacuate the evacuation port 516 of the main evacuation pump 510. The controller 400 operates the main evacuation pump 510 and waits until the rotational speed of the main evacuation pump 510 reaches a steady state.

After the rotational speed of the main evacuation pump 510 reaches the steady state, the controller 400 closes the fourth valve 534, opens the fifth valve 535, and causes the sub-evacuation pump 520 to evacuate the sample chamber 202 (step S102).

The controller 400 determines whether the vacuum degree inside the sample chamber 202 has reached the vacuum degree at which the main evacuation pump 510 is enabled to perform evacuation, based on the power and temperature of the sub-evacuation pump 520 (step S104). For example, when the vacuum degree inside the sample chamber 202 is low, evacuating the sample chamber 202 with the main evacuation pump 510 may place a load on the main evacuation pump 510, potentially leading to damage of the main evacuation pump 510. Therefore, in the process of step S104, the controller 400 determines whether the vacuum degree inside the sample chamber 202 has reached the vacuum degree at which the main evacuation pump 510 is enabled to perform evacuation.

Here, the power consumption of the sub-evacuation pump 520 corresponds to the vacuum degree inside the sample chamber 202. As the vacuum degree inside the sample chamber 202 increases, that is, as the pressure inside the sample chamber 202 decreases, the power consumption of the sub-evacuation pump 520 decreases. Furthermore, the relationship between the vacuum degree inside the sample chamber 202 and the power consumption of the sub-evacuation pump 520 varies depending on the temperature of the sub-evacuation pump 520. For example, in a diaphragm pump, the diaphragm becomes stiffer as the temperature decreases, and as a result, the power consumption increases as the temperature decreases.

Accordingly, the relationship between the power consumption of the sub-evacuation pump 520 and the vacuum degree inside the sample chamber 202 is examined in advance for each temperature of the sub-evacuation pump 520. As a result, it is possible to determine the vacuum degree inside the sample chamber 202 from the temperature and the power consumption of the sub-evacuation pump 520.

For example, the storage device of the controller 400 stores a table that shows the relationship between the power consumption of the sub-evacuation pump 520 and the vacuum degree inside the sample chamber 202 at each temperature of the sub-evacuation pump 520. The controller 400 acquires information on the power consumption and the temperature of the sub-evacuation pump 520, refers to the table stored in the storage device, and calculates the vacuum degree inside the sample chamber 202 using the acquired information on the power consumption and the temperature. The controller 400 compares the calculated vacuum degree with the vacuum degree at which the main evacuation pump 510 is enabled to perform evacuation to determine whether the vacuum degree inside the sample chamber 202 has reached the vacuum degree at which the main evacuation pump 510 is enabled to perform evacuation.

When it is determined that the vacuum degree inside the sample chamber 202 has not reached the vacuum degree at which the main evacuation pump 510 is enabled to perform evacuation (No in step S 104), the controller 400 repeatedly performs the process of step S104 until the vacuum degree inside the sample chamber 202 reaches the vacuum degree at which the main evacuation pump 510 is enabled to perform evacuation.

When it is determined that the vacuum degree inside the sample chamber 202 has reached the vacuum degree at which the main evacuation pump 510 is enabled to perform evacuation (Yes in step S104), the controller 400 closes the fifth valve 535, opens the first valve 531 and the fourth valve 534, and causes the main evacuation pump 510 to evacuate the sample chamber 202 (step S106). As a result, the sample chamber 202 is evacuated by the main evacuation pump 510, and the evacuation port 516 of the main evacuation pump 510 is evacuated by the sub-evacuation pump 520. Accordingly, it is possible to set the sample chamber 202 to a vacuum degree at which the sample S can be introduced. The controller 400 ends the process after step S106.

Note that in the process of step S104, the relationship between the power consumption of the sub-evacuation pump 520 and the vacuum degree inside the sample chamber 202 is represented as a table, but it may also be represented as a relational expression. In other words, the storage device of the controller 400 may also store the relational expression. The same applies to the process, which will be described later.

Furthermore, in the process of step S104, the controller 400 compares the vacuum degree calculated using the power consumption of the sub-evacuation pump 520 with the vacuum degree inside the sample chamber 202 at which the main evacuation pump 510 is enabled to perform evacuation. Alternatively, it may compare the power consumption of the sub-evacuation pump 520 with the power consumption value of the sub-evacuation pump 520 corresponding to the vacuum degree inside the sample chamber 202 at which the main evacuation pump 510 is enabled to perform evacuation.

Specifically, the controller 400 may calculate in advance the power consumption value of the sub-evacuation pump 520 corresponding to the vacuum degree inside the sample chamber 202 at which the main evacuation pump 510 is enabled to perform evacuation and store the value in the storage device. Then, the controller 400 may compare the power consumption value stored in the storage device with the power consumption of the sub-evacuation pump 520 to determine whether the vacuum degree inside the sample chamber 202 has reached the vacuum degree at which the main evacuation pump 510 is enabled to perform evacuation. The same applies to the process, which will be described later.

Furthermore, in the process of step S104, the controller 400 determines the vacuum degree based on the power consumption of the sub-evacuation pump 520. Alternatively, when the voltage consumption of the sub-evacuation pump 520 is constant, the controller 400 may determine the vacuum degree based on the current consumption of the sub-evacuation pump 520. Furthermore, when the current consumption of the sub-evacuation pump 520 is constant, the controller 400 may determine the vacuum degree based on the voltage consumption of the sub-evacuation pump 520. As described above, determining the vacuum degree based on the power consumption of the sub-evacuation pump 520 includes determining the vacuum degree based on the current consumption of the sub-evacuation pump 520 and determining the vacuum degree based on the voltage consumption of the sub-evacuation pump 520. The same applies to the process, which will be described later.

### 1.2.2. Operation of Vacuum Pumping System during Introduction of Sample

FIG. 6 is a flowchart illustrating an example of the control process of the vacuum pumping system 500 during the introduction of the sample S into the sample chamber 202. Here, the control process illustrated in FIG. 6 is performed after the above control process illustrated in FIG. 5. In other words, in an initial state, the sample chamber 202 is evacuated by the main evacuation pump 510 with the first valve 531 open, and the sample chamber 202 is set to the vacuum degree at which the sample S can be introduced.

The controller 400 determines whether the sample S supported by the sample holder 300 has been introduced into the pre-evacuation chamber 232 (step S200). The controller 400 determines that the sample S has been introduced into the pre-evacuation chamber 232, based on a notification from a sensor that detects the introduction of the sample S into the pre-evacuation chamber 232, a user's input indicating that the sample S has been introduced into the pre-evacuation chamber 232, or the like.

When it is determined that the sample S has been introduced into the pre-evacuation chamber 232 (Yes in step S200), the controller 400 opens the third valve 533 and causes the sub-evacuation pump 520 to evacuate the pre-evacuation chamber 232 (step S202).

Next, the controller 400 determines whether the vacuum degree inside the pre-evacuation chamber 232 has reached a first vacuum degree based on the power and temperature of the sub-evacuation pump 520 (step S204). The first vacuum degree represents the vacuum degree inside the pre-evacuation chamber 232 at which the main evacuation pump 510 is enabled to perform evacuation. For example, when the pre-evacuation chamber 232 is evacuated by the main evacuation pump 510 in a low vacuum state where the vacuum degree inside the pre-evacuation chamber 232 has not reached the first vacuum degree, a load may be placed on the main evacuation pump 510, potentially leading to damage of the main evacuation pump 510.

Here, the power consumption of the sub-evacuation pump 520 corresponds to the vacuum degree inside the pre-evacuation chamber 232 and decreases as the vacuum degree inside the pre-evacuation chamber 232 increases. Furthermore, the relationship between the vacuum degree inside the pre-evacuation chamber 232 and the power consumption of the sub-evacuation pump 520 varies depending on the temperature of the sub-evacuation pump 520. Therefore, the relationship between the power consumption of the sub-evacuation pump 520 and the vacuum degree inside the pre-evacuation chamber 232 is examined in advance for each temperature of the sub-evacuation pump 520. As a result, it is possible to determine the vacuum degree inside the pre-evacuation chamber 232 from the temperature and the power consumption of the sub-evacuation pump 520.

For example, the storage device of the controller 400 stores a table that shows the relationship between the power consumption of the sub-evacuation pump 520 and the vacuum degree inside the pre-evacuation chamber 232 at each temperature of the sub-evacuation pump 520. The controller 400 acquires information on the power consumption and the temperature of the sub-evacuation pump 520, refers to the table stored in the storage device, and calculates the vacuum degree inside the pre-evacuation chamber 232 using the acquired information on the power consumption and the temperature. The controller 400 compares the calculated vacuum degree with the first vacuum degree to determine whether the vacuum degree inside the pre-evacuation chamber 232 has reached the first vacuum degree.

Note that the controller 400 may also compare the power consumption of the sub-evacuation pump 520 with the power consumption value of the sub-evacuation pump 520 corresponding to the first vacuum degree to determine whether the vacuum degree inside the pre-evacuation chamber 232 has reached the first vacuum degree.

When it is determined that the vacuum degree inside the pre-evacuation chamber 232 has not reached the first vacuum degree (No in step S204), the controller 400 repeatedly performs the process in step S204 until the vacuum degree inside the pre-evacuation chamber 232 reaches the first vacuum degree.

When it is determined that the vacuum degree inside the pre-evacuation chamber 232 has reached the first vacuum degree (Yes in step S204), the controller 400 closes the third valve 533, opens the second valve 532, and causes the main evacuation pump 510 to evacuate the pre-evacuation chamber 232 (step S206). At this time, the controller 400 may operate the sub-evacuation pump 520, open the fourth valve 534, and cause the sub-evacuation pump 520 to evacuate the evacuation port 516 of the main evacuation pump 510.

Next, the controller 400 determines whether the vacuum degree inside the pre-evacuation chamber 232 has reached a second vacuum degree based on the power consumption of the main evacuation pump 510 (step S208). The second vacuum degree represents the vacuum degree at which the partition valve 234 is capable of being opened. For example, the second vacuum degree represents the vacuum degree at which no discharge occurs in the electron gun chamber even when the partition valve 234 is opened. In the transmission electron microscope 2, the sample chamber 202 and the electron gun chamber are in communication with each other. As a result, when the vacuum degree inside the sample chamber 202 decreases, the vacuum degree inside the electron gun chamber also decreases, potentially leading to the occurrence of a discharge. Therefore, the value of the second vacuum degree is set to prevent a discharge from occurring in the electron gun chamber even when the partition valve 234 is opened.

Here, the power consumption of the main evacuation pump 510 corresponds to the vacuum degree inside the pre-evacuation chamber 232 and decreases as the vacuum degree inside the pre-evacuation chamber 232 increases. Therefore, the relationship between the power consumption of the main evacuation pump 510 and the vacuum degree inside the pre-evacuation chamber 232 is examined in advance. As a result, it is possible to determine the vacuum degree inside the pre-evacuation chamber 232 from the power consumption of the main evacuation pump 510.

For example, the storage device of the controller 400 stores a table that shows the relationship between the power consumption of the main evacuation pump 510 and the vacuum degree inside the pre-evacuation chamber 232. The controller 400 acquires information on the power consumption of the main evacuation pump 510, refers to the table stored in the storage device, and calculates the vacuum degree inside the pre-evacuation chamber 232 using the acquired information on the power consumption. The controller 400 compares the calculated vacuum degree with the second vacuum degree to determine whether the vacuum degree inside the pre-evacuation chamber 232 has reached the second vacuum degree.

Note that while the temperature of the sub-evacuation pump 520 changes, the temperature of the main evacuation pump 510 remains almost constant because it operates continuously. Furthermore, the temperature dependence of the power consumption of the main evacuation pump 510 is smaller than that of the sub-evacuation pump 520. Accordingly, here, the impact of the temperature of the main evacuation pump 510 is not considered when calculating the vacuum degree inside the pre-evacuation chamber 232 using the power consumption of the main evacuation pump 510. Note that, like the sub-evacuation pump 520, the impact of the temperature of the main evacuation pump 510 may be considered when calculating the vacuum degree inside the pre-evacuation chamber 232 using the power consumption of the main evacuation pump 510.

When it is determined that the vacuum degree inside the pre-evacuation chamber 232 has not reached the second vacuum degree (No in step S208), the controller 400 repeatedly performs the process in step S208 until the vacuum degree inside the pre-evacuation chamber 232 reaches the second vacuum degree.

When it is determined that the vacuum degree inside the pre-evacuation chamber 232 has reached the second vacuum degree (Yes in step S208), the controller 400 notifies that the sample S can be introduced into the sample chamber 202 (step S210). The transmission electron microscope 2 is provided with, for example, an indirect illumination at the bottom of the recessed portion 110 of the housing 100 and notifies the user that the sample S can be introduced into the sample chamber 202 by lighting or blinking the indirect illumination. Note that the notification means is not particularly limited. For example, the color of the light emitted from the indirect illumination may be changed, a notification via a beep sound or the like may be sent, or a message may be displayed on a display unit. The controller 400 ends the process after the notification (after step S210).

Upon receiving the notification, the user operates the sample holder 300 to introduce the sample S from the pre-evacuation chamber 232 into the sample chamber 202. Here, the holder support portion 230 is provided with a guide groove to guide the sample holder 300. Guiding the sample holder 300 along the guide groove enables the sample S to be moved from the pre-evacuation chamber 232 into the sample chamber 202. The guide groove is provided with a switch to open the partition valve 234. Therefore, the controller 400 opens the partition valve 234 when detecting that the switch has been pressed by the sample holder 300. As a result, it is possible to introduce the sample S from the pre-evacuation chamber 232 into the sample chamber 202.

### 1.2.3. Operation of Vacuum Pumping System during Examination

In the transmission electron microscope 2, the sub-evacuation pump 520 is stored in the console connected to the body portion 200. The transmission electron microscope 2 does not include a vibration isolation mechanism to prevent the vibrations of the sub-evacuation pump 520 from being transmitted to the body portion 200. Therefore, the operation of the sub-evacuation pump 520 during examination leads to an impact on observation. Therefore, during examination, that is, when the sample S is illuminated with an electron beam, it is desirable that the sub-evacuation pump 520 not operate.

The main evacuation pump 510 is unable to operate alone, and the evacuation port 516 needs to be evacuated by the sub-evacuation pump 520 to reduce the backing pressure. Assuming that no gas emission, leakage, or the like occurs from the space that is evacuated by the main evacuation pump 510, the backing pressure of the main evacuation pump 510 does not increase even if the sub-evacuation pump 520 stops at the pressure reached by the system.

However, because it is not possible to zero gas emission and leakage, the backing pressure of the main evacuation pump 510 increases when the fourth valve 534 is closed. When this state is maintained, gas starts reversing before the backing pressure of the main evacuation pump 510 reaches the critical backing pressure, and the vacuum degree inside the sample chamber 202 decreases. When the backing pressure of the main evacuation pump 510 exceeds the critical backing pressure, the main evacuation pump 510 stops. In order to prevent this, the backing pressure of the main evacuation pump 510 needs to be reduced before reaching the critical backing pressure.

If the time for which the sub-evacuation pump 520 stops is made sufficiently longer than the time required for examination, the examination will not be affected. In order to increase the time for which the sub-evacuation pump 520 stops, the material, diameter, and length of an evacuation tube that connects the evacuation port 516 and the fourth valve 534 are optimized in the transmission electron microscope 2. Specifically, the evacuation tube is made of metal, and the diameter and the length are adjusted to increase the volume of the space between the evacuation port 516 and the fourth valve 534. In the transmission electron microscope 2, the time for which the sub-evacuation pump 520 stops is, for example, approximately 30 hours.

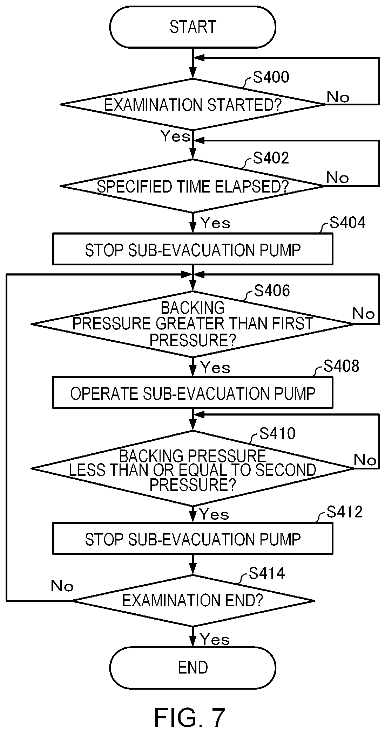

FIG. 7 is a flowchart illustrating an example of the control process of the vacuum pumping system 500 during examination. Here, in an initial state during examination, the sample S is placed in the sample chamber 202, the sample chamber 202 is evacuated by the main evacuation pump 510 with the first valve 531 open, and the evacuation port 516 of the main evacuation pump 510 is evacuated by the sub-evacuation pump 520 with the fourth valve 534 open.

The controller 400 determines whether examination has started (step S400). The controller 400 determines that the examination has started when the user opens a gun shutter (not shown). The gun shutter is a mechanism to switch between the ON and OFF states of an electron beam and is provided at the lower stage of the electron gun 210.

Next, the controller 400 determines whether a specified time has elapsed since the start of the examination (step S402). The controller 400 determines whether the specified time has elapsed since the opening of the gun shutter. When it is determined that the specified time has elapsed since the start of the examination (Yes in step S402), the controller 400 closes the fourth valve 534 to stop the sub-evacuation pump 520 (step S404).

Because observation is typically performed at a low magnification immediately after the examination starts, the effect of the operation of the sub-evacuation pump 520 is small. Therefore, the controller 400 stops the sub-evacuation pump 520 after the specified time has elapsed since the start of the examination. After stopping the sub-evacuation pump 520, observation at a high magnification and photographing become possible.

The controller 400 determines whether the backing pressure of the main evacuation pump 510 is greater than a first pressure based on the power consumption of the main evacuation pump 510 after stopping the sub-evacuation pump 520 (step S406). The first pressure is set according to, for example, the critical backing pressure. The first pressure is set to a pressure lower than the critical backing pressure.

Here, the power consumption of the main evacuation pump 510 corresponds to the backing pressure of the main evacuation pump 510 and decreases as the backing pressure of the main evacuation pump 510 decreases. In the turbo molecular pump, the power consumption increases to maintain a constant rotational speed as the backing pressure increases.

Therefore, the relationship between the power consumption and the backing pressure of the main evacuation pump 510 is examined in advance. As a result, it is possible to determine the backing pressure from the power consumption of the main evacuation pump 510.

For example, the storage device of the controller 400 stores information on the power consumption of the main evacuation pump 510 corresponding to the first pressure. The controller 400 acquires information on the power consumption of the main evacuation pump 510 and compares the acquired information on the power consumption with the power consumption value stored in the storage device to determine whether the backing pressure of the main evacuation pump 510 becomes greater than the first pressure. When the power consumption of the main evacuation pump 510 becomes greater than the power consumption corresponding to the first pressure, the controller 400 determines that the backing pressure of the main evacuation pump 510 becomes greater than the first pressure.

When it is determined that the backing pressure of the main evacuation pump 510 is less than or equal to the first pressure (No in step S406), the controller 400 repeatedly performs the process in step S406. When it is determined that the backing pressure of the main evacuation pump 510 is greater than the first pressure (Yes in step S406), the controller 400 operates the sub-evacuation pump 520, opens the fourth valve 534, and causes the sub-evacuation pump 520 to evacuate the evacuation port 516 of the main evacuation pump 510 (step S408). The controller 400 causes the sub-evacuation pump 520 to evacuate the evacuation port 516 for a preset time, for example. As a result, it is possible to reduce the backing pressure of the main evacuation pump 510. The controller 400 causes the sub-evacuation pump 520 to evacuate the evacuation port 516 for approximately five minutes, for example.

Next, after operating the sub-evacuation pump 520 for the preset time, the controller 400 determines whether the backing pressure of the main evacuation pump 510 becomes less than or equal to a second pressure based on the power consumption of the main evacuation pump 510 (step S410). The controller 400 determines that the backing pressure of the main evacuation pump 510 becomes less than or equal to the second pressure when the power consumption of the main evacuation pump 510 becomes less than or equal to the power consumption corresponding to the second pressure.

Here, the second pressure is set to, for example, a pressure lower than the first pressure. By setting the second pressure at a low value, it is possible to increase the time for which the sub-evacuation pump 520 stops. However, the operating time of the sub-evacuation pump 520 increases as the second pressure is set to a lower value. Note that the process in step S410 is performed in the same manner as the above process in step S406, except that the determination criterion is set to the second pressure.

When it is determined that the backing pressure of the main evacuation pump 510 is not less than or equal to the second pressure (No in step S410), the controller 400 repeatedly performs the process in step S410. When it is determined that the backing pressure of the main evacuation pump 510 is less than or equal to the second pressure (Yes in step S410), the controller 400 closes the fourth valve 534 to stop the operation of the sub-evacuation pump 520 (step S412).

Next, the controller 400 determines whether the user has ended the examination (step S414). The controller 400 determines that the examination has ended when the user closes the gun shutter (not shown).

When it is determined that the examination has not ended (No in step S414), the controller 400 returns to the process in step S406. The controller 400 repeatedly performs the processes in steps S406, S408, S410, S412, and S414 until it is determined that the examination has ended. As a result, it is possible to prevent the backing pressure of the main evacuation pump from becoming greater than the first pressure and the vacuum degree inside the sample chamber 202 at a constant level. The controller 400 ends the process when it is determined that the examination has ended (Yes in step S414).

Note that as described above, in the transmission electron microscope 2, the main evacuation pump 510 is capable of maintaining the backing pressure for approximately 30 hours even when the sub-evacuation pump 520 stops. Therefore, the above process in step S408 will not be performed, for example, unless the examination time exceeds 30 hours.

### 1.2.4. Modified Example of Operation of Vacuum Pumping System during Examination

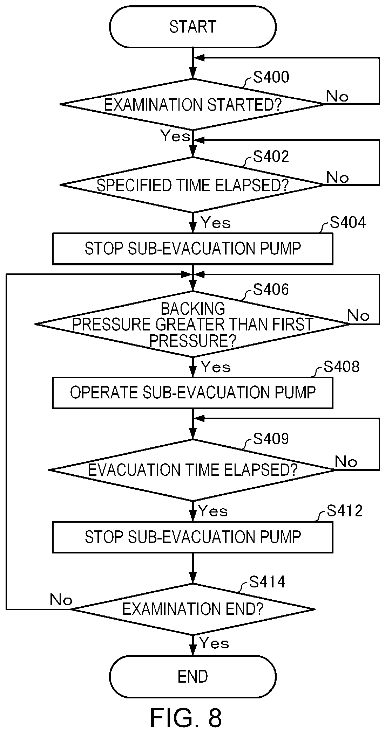

FIG. 8 is a flowchart illustrating a modified example of the control process of the vacuum pumping system 500 during examination.

In the example in FIG. 7, the controller 400 operates the sub-evacuation pump 520 (step S408) when the backing pressure of the main evacuation pump 510 becomes greater than the first pressure (Yes in step S406) and stops the sub-evacuation pump 520 (step S412) when the backing pressure of the main evacuation pump 510 becomes less than or equal to the second pressure (Yes in step S410).

On the other hand, the controller 400 may operate the sub-evacuation pump 520 (step S408) when the backing pressure of the main evacuation pump 510 becomes greater than the first pressure (Yes in step S406) and stop the sub-evacuation pump 520 (step S412) after the elapse of a preset evacuation time (Yes in step S409). By setting the time until the backing pressure of the main evacuation pump 510 becomes less than or equal to the second pressure after the sub-evacuation pump 520 starts evacuating the evacuation port 516 as the preset evacuation time, the same effect as that in the above example in FIG. 7 may be achieved.

### 1.2.5. Operation of Vacuum Pumping System during Non-Examination

During non-examination, that is, when the sample S is not illuminated with an electron beam, the sub-evacuation pump 520 operates, and no issues arise even if the body portion 200 vibrates. However, the continuous operation of the sub-evacuation pump 520 shortens its life span. Therefore, it is possible to extend the life span of the sub-evacuation pump 520 by operating the sub-evacuation pump 520 intermittently.

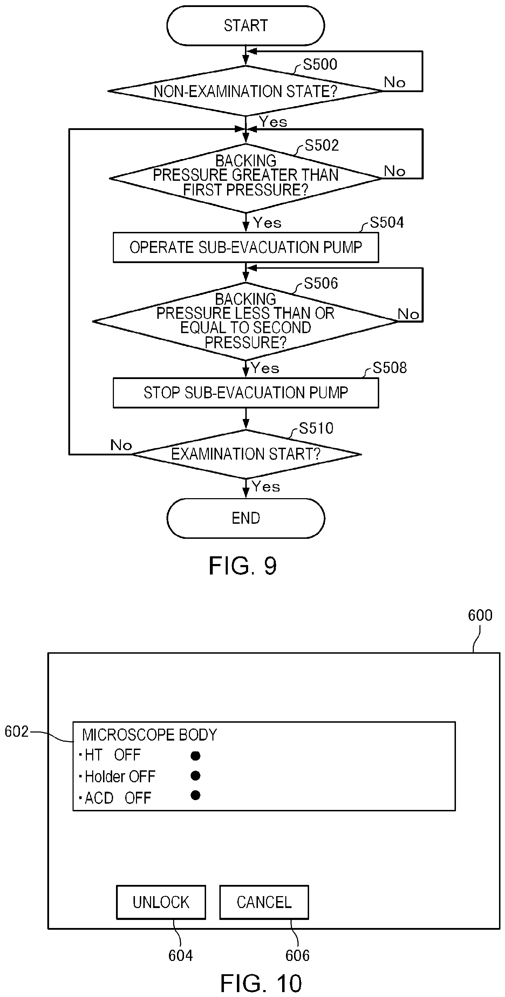

FIG. 9 is a flowchart illustrating an example of the control process of the vacuum pumping system 500 during non-examination. Here, in an initial state during non-examination, the sample chamber 202 is evacuated by the main evacuation pump 510.

The controller 400 determines whether the vacuum pumping system 500 is in a non-examination state (step S500). The controller 400 determines that the vacuum pumping system 500 is in the non-examination state when the user closes the gun shutter (not shown).

When it is determined that the vacuum pumping system 500 is in the non-examination state (Yes in step S500), the controller 400 determines whether the backing pressure of the main evacuation pump 510 is greater than the first pressure based on the power consumption of the main evacuation pump 510 (step S502). The process in step S502 is performed in the same manner as that in step S406 illustrated in FIG. 7.

When it is determined that the backing pressure of the main evacuation pump 510 is not greater than the first pressure (No in step S502), the controller 400 repeatedly performs the process in step S502. When it is determined that the backing pressure of the main evacuation pump 510 is greater than the first pressure (Yes in step S502), the controller 400 operates the sub-evacuation pump 520, opens the fourth valve 534, and causes the sub-evacuation pump 520 to evacuate the evacuation port 516 of the main evacuation pump 510 (step S504). As a result, it is possible to reduce the backing pressure of the main evacuation pump 510.

Next, the controller 400 determines whether the backing pressure of the main evacuation pump 510 is less than or equal to the second pressure based on the power consumption of the main evacuation pump 510 (step S506). The process in step S506 is performed in the same manner as that in step S410 illustrated in FIG. 7.

When it is determined that the backing pressure of the main evacuation pump 510 is not less than or equal to the second pressure (No in step S506), the controller 400 repeatedly performs the process in step S506. When it is determined that the backing pressure of the main evacuation pump 510 is less than or equal to the second pressure (Yes in step S506), the controller 400 stops the operation of the sub-evacuation pump 520 (step S508).

As described above, the processes in steps S502, S504, S506, and S508 are, respectively, performed in the same manner as those in steps S406, S408, S410, and S412 illustrated in FIG. 7.

Next, the controller 400 determines whether examination has started (step S510). The controller 400 determines that the examination has started when the user opens the gun shutter (not shown). When it is determined that the examination has not started (No in step S510), the controller 400 returns to step S502. The controller 400 repeatedly performs the processes in steps S502, S504, S506, S508, and S510 until it is determined that the examination has started. The controller 400 ends the process when it is determined that the examination has started (Yes in step S510).

Note that the modified example of the process during examination illustrated in FIG. 8 may also be applied to the above process during non-examination illustrated in FIG. 9.

### 1.2.6. Operation during Venting

Inside the electron optical column 204, there is a unit cooled by liquid nitrogen or a Peltier device. Examples of such units include a cooling unit for a charge-coupled device (CCD) camera used as the imager 250, a cold trap used as an anti-contamination device, and the like. When the interior of the electron optical column 204 is vented for the maintenance of the device, these units may be damaged if venting in the electron optical column 204 is performed in a state where the units remain cooled.

In the transmission electron microscope 2, in order to prevent damage to the units, unlocking is performed on the screen of an operating computer separate from the computer that constitutes the controller 400, and then venting is performed through the venting operation button of the operation unit 130.

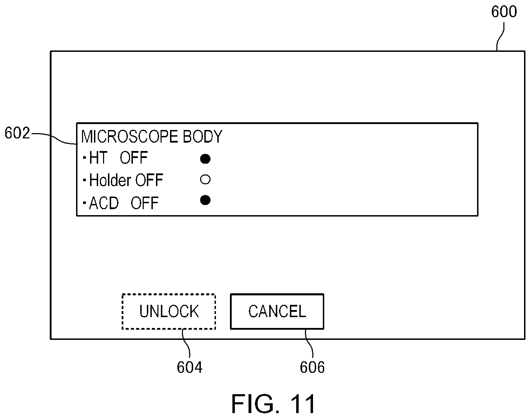

FIGS. 10 and 11 are diagrams schematically illustrating a graphical user interface (GUI) screen 600 of the operating computer.

The GUI screen 600 has a box 602 to confirm the state of the device. The box 602 allows the confirmation of whether venting of the electron optical column 204 is possible. In the illustrated example, the box 602 allows the confirmation of whether an accelerating voltage (HT) is applied, whether the sample holder 300 is inserted, and whether an anti-contamination device (ACD) is in operation.

The GUI screen 600 has an unlocking button 604 for unlocking and a cancel button 606. For example, when all the items in the box 602 are enabled as illustrated in FIG. 10, the unlocking button 604 lights up. Pressing the unlocking button 604 implements unlocking, activating the venting operation button on the touch panel, which functions as the operation unit 130, for a fixed time.

Furthermore, for example, when all the items in the box 602 are not enabled as illustrated in FIG. 11, the unlocking button 604 extinguishes, and only the cancel button 606 lights up.

When the venting operation button of the operation unit 130 is pressed, the controller 400 closes the first valve 531, the second valve 532, the third valve 533, and the fifth valve 535, and opens the fourth valve 534. Furthermore, the controller 400 operates the main evacuation pump 510 and the sub-evacuation pump 520. When the leak valve 536 is opened in this state, the electron optical column 204 is vented.

When the interior of the electron optical column 204 is evacuated from a vented state to a state where the sample S can be introduced into the sample chamber 202, it is sufficient to perform the control process of the vacuum pumping system 500 illustrated in FIG. 5.

### 1.3. Effects

The transmission electron microscope 2 includes: the sample chamber 202 where the sample S is placed; the pre-evacuation chamber 232 that is connected to the sample chamber 202 via the partition valve 234; the main evacuation pump 510 that has the first port 512, the second port 514, and the evacuation port 516, the first port 512 being connected to the sample chamber 202, the second port 514 being connected to the pre-evacuation chamber 232; and the sub-evacuation pump 520 that is connected to the pre-evacuation chamber 232, the evacuation port 516, and the sample chamber 202. Moreover, the transmission electron microscope 2 includes the controller 400 that controls the main evacuation pump 510 and the sub-evacuation pump 520.

Furthermore, the controller 400 performs: the process of causing the sub-evacuation pump 520 to evacuate the pre-evacuation chamber 232 when the sample S is introduced into the pre-evacuation chamber 232; the process of determining whether the vacuum degree inside the pre-evacuation chamber 232 has reached a first vacuum degree based on the power of the sub-evacuation pump 520; and the process of causing the main evacuation pump 510 to evacuate the pre-evacuation chamber 232 when it is determined that the vacuum degree inside the pre-evacuation chamber 232 has reached the first vacuum degree.

Therefore, in the transmission electron microscope 2, the pre-evacuation chamber 232 is capable of being evacuated by the main evacuation pump 510. As a result, when introducing the sample S from the pre-evacuation chamber 232 into the sample chamber 202 with the partition valve 234 open, it is possible to reduce a reduction in the vacuum degree inside the sample chamber 202 compared to evacuating the pre-evacuation chamber 232 by only the sub-evacuation pump 520. Moreover, in the transmission electron microscope 2, the vacuum degree inside the pre-evacuation chamber 232 is determined from the power of the sub-evacuation pump 520. Therefore, a vacuum gauge to measure the vacuum degree inside the pre-evacuation chamber 232 is not required. Accordingly, it is possible to reduce the number of components in the transmission electron microscope 2.

Furthermore, in the transmission electron microscope 2, the interior of the electron optical column 204 including the sample chamber 202 and the pre-evacuation chamber 232 are capable of being evacuated by the single main evacuation pump 510 and the single sub-evacuation pump 520. Therefore, it is possible to realize the vacuum pumping system 500 with a simple configuration.

In the transmission electron microscope 2, the sample chamber 202 and the electron gun chamber are in communication with each other. In the transmission electron microscope 2, the pre-evacuation chamber 232 is capable of being evacuated by the main evacuation pump 510. Therefore, when introducing the sample S from the pre-evacuation chamber 232 into the sample chamber 202 with the partition valve 234 open, it is possible to reduce a reduction in the vacuum degree inside the sample chamber 202. As a result, in the transmission electron microscope 2, when introducing the sample S into the sample chamber 202, it is possible to reduce the likelihood of a discharge due to a reduction in the vacuum degree inside the electron gun chamber. Accordingly, in the transmission electron microscope 2, it is possible to introduce the sample S from the pre-evacuation chamber 232 into the sample chamber 202 even while the electron gun 210 is generating an electron beam.

The transmission electron microscope 2 includes the temperature gauge 522 that measures the temperature of the sub-evacuation pump 520. The controller 400 determines whether the vacuum degree inside the pre-evacuation chamber 232 has reached a first vacuum degree based on the power and temperature of the sub-evacuation pump 520 during the process of determining whether the vacuum degree inside the pre-evacuation chamber 232 has reached the first vacuum degree. Therefore, in the transmission electron microscope 2, it is possible to accurately determine the vacuum degree inside the pre-evacuation chamber 232 from the temperature of the sub-evacuation pump 520 even if the relationship between the vacuum degree inside the sample chamber 202 and the power consumption of the sub-evacuation pump 520 varies. Accordingly, in the transmission electron microscope 2, it is possible to accurately determine the timing for causing the main evacuation pump 510 to evacuate the pre-evacuation chamber 232.

In the transmission electron microscope 2, after the process of causing the main evacuation pump 510 to evacuate the pre-evacuation chamber 232, the controller 400 performs the process of determining whether the vacuum degree inside the pre-evacuation chamber 232 has reached a second vacuum degree, based on the power of the main evacuation pump 510; and when the vacuum degree inside the pre-evacuation chamber 232 has reached the second vacuum degree, the controller 400 performs the process of notifying that the sample S can be introduced into the sample chamber 202. Therefore, in the transmission electron microscope 2, it is possible to determine the timing for introducing the sample S from the pre-evacuation chamber 232 into the sample chamber 202. Moreover, in the transmission electron microscope 2, the vacuum degree inside the pre-evacuation chamber 232 is determined from the power of the main evacuation pump 510. Therefore, a vacuum gauge to measure the vacuum degree inside the pre-evacuation chamber 232 is not required. Accordingly, it is possible to reduce the number of components in the transmission electron microscope 2.

In the transmission electron microscope 2, the controller 400 performs: the process of causing the main evacuation pump 510 to evacuate the sample chamber 202; the process of stopping the sub-evacuation pump 520; the process of determining whether the backing pressure of the main evacuation pump 510 is greater than a first pressure based on the power of the main evacuation pump 510; and the process of causing the sub-evacuation pump 520 to evacuate the evacuation port 516 of the main evacuation pump 510 when it is determined that the backing pressure of the main evacuation pump 510 is greater than the first pressure. Moreover, the controller 400 performs: the process of determining whether the backing pressure of the main evacuation pump 510 is less than or equal to a second pressure based on the power of the main evacuation pump 510; and the process of stopping the sub-evacuation pump 520 when it is determined that the backing pressure of the main evacuation pump 510 is less than or equal to the second pressure. As described above, in the transmission electron microscope 2, the sub-evacuation pump 520 operates intermittently. Therefore, it is possible to extend the life span of the sub-evacuation pump 520. Moreover, in the transmission electron microscope 2, the backing pressure of the main evacuation pump 510 is determined from the power of the main evacuation pump 510. Therefore, for example, a vacuum gauge to measure the backing pressure of the main evacuation pump 510 is not required. Accordingly, it is possible to reduce the number of components in the transmission electron microscope 2.

The control method for the transmission electron microscope 2 includes: the step of causing the sub-evacuation pump 520 to evacuate the pre-evacuation chamber 232 when the sample S is introduced into the pre-evacuation chamber 232; the step of determining whether the vacuum degree inside the pre-evacuation chamber 232 has reached a first vacuum degree based on the power of the sub-evacuation pump 520; and the step of causing the main evacuation pump 510 to evacuate the pre-evacuation chamber 232 when it is determined that the vacuum degree inside the pre-evacuation chamber 232 has reached the first vacuum degree. As described above, in the control method for the transmission electron microscope 2, the pre-evacuation chamber 232 is evacuated by the main evacuation pump 510. Therefore, when introducing the sample S from the pre-evacuation chamber 232 into the sample chamber 202 with the partition valve 234 open, it is possible to reduce a reduction in the vacuum degree inside the sample chamber 202.

### 1.4. Modified Example

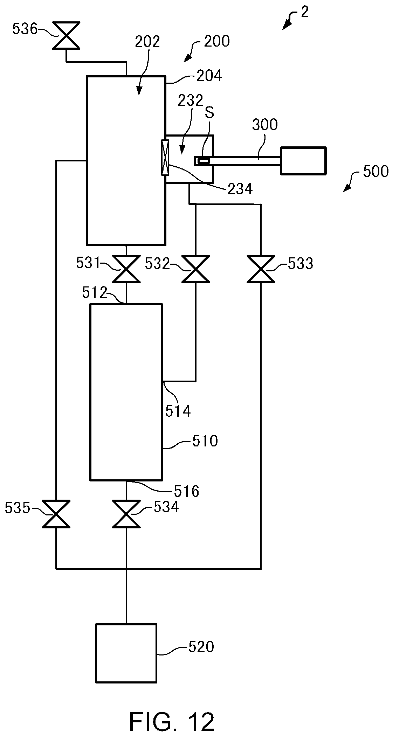

FIG. 12 is a diagram illustrating a modified example of the configuration of the vacuum pumping system 500 of the transmission electron microscope 2 according to the first embodiment.

In the above first embodiment, the power consumption of the sub-evacuation pump 520 varies with temperature. Therefore, the relationship between the vacuum degree inside the sample chamber 202 and the power consumption of the sub-evacuation pump 520 varies depending on the temperature of the sub-evacuation pump 520. Similarly, the relationship between the vacuum degree inside the pre-evacuation chamber 232 and the power consumption of the sub-evacuation pump 520 varies depending on the temperature of the sub-evacuation pump 520. Therefore, as illustrated in FIG. 4, the transmission electron microscope 2 has the temperature gauge 522 to measure the temperature of the sub-evacuation pump 520.

On the other hand, in this modified example, a pump that does not vary in power consumption with temperature is used as the sub-evacuation pump 520. Accordingly, in this modified example, the relationship between the vacuum degree inside the sample chamber 202 and the power consumption of the sub-evacuation pump 520 is not affected by the temperature of the sub-evacuation pump 520. Furthermore, the relationship between the vacuum degree inside the pre-evacuation chamber 232 and the power consumption of the sub-evacuation pump 520 is not affected by the temperature of the sub-evacuation pump 520. Therefore, as illustrated in FIG. 12, the transmission electron microscope 2 does not have a temperature gauge to measure the temperature of the sub-evacuation pump 520.

In this modified example, in the process of step S104 illustrated in FIG. 5, a determination is made as to whether the vacuum degree inside the sample chamber 202 has reached the vacuum degree at which the main evacuation pump 510 is enabled to perform evacuation, based on the power consumption of sub-evacuation pump 520 without considering the temperature of the sub-evacuation pump 520. Furthermore, in the process of step S204 illustrated in FIG. 6, a determination is made as to whether the vacuum degree inside the pre-evacuation chamber 232 has reached the vacuum degree (first vacuum degree) at which the main evacuation pump 510 is enabled to perform evacuation, based on the power consumption of the sub-evacuation pump 520 without considering the temperature of the sub-evacuation pump 520.

### 2. Second Embodiment

### 2.1. Configuration of Transmission Electron Microscope

Next, a transmission electron microscope according to the second embodiment will be described. The transmission electron microscope according to the second embodiment is the same as the above transmission electron microscope 2 illustrated in FIG. 1, and its description will be omitted.

### 2.2. Operation

### 2.2.1. Operation of Vacuum Pumping System during Evacuation of Sample Chamber

The control process of an vacuum pumping system 500 during the evacuation of a sample chamber 202 is the same as the above control process illustrated in FIG. 5, and its description will be omitted.

### 2.2.2. Operation of Vacuum Pumping System during Introduction of Sample

The control process of the vacuum pumping system 500 when a sample S is introduced into the sample chamber 202 differs from the above control process illustrated in FIG. 6 in the process of step S204. Hereinafter, the point different from the above point of the first embodiment will be described, and the description of the same point will be omitted.

In the above first embodiment, in the process of step S204, the controller 400 determines whether the vacuum degree inside the pre-evacuation chamber 232 has reached the vacuum degree (first vacuum degree) at which the main evacuation pump 510 is enabled to perform evacuation, based on the power and temperature of the sub-evacuation pump 520.

On the other hand, in the second embodiment, the temperature of a sub-evacuation pump 520 is capable of being maintained within a temperature range where the relationship between the vacuum degree inside a pre-evacuation chamber 232 and the power consumption of the sub-evacuation pump 520 remains changed, as will be described in "2.3.4. Operation of Vacuum pumping system during Non-Examination." Accordingly, in the process of step S204, a controller 400 determines whether the vacuum degree inside the pre-evacuation chamber 232 has reached a first vacuum degree, based on the power of the sub-evacuation pump 520 without considering the temperature of the sub-evacuation pump 520.

For example, the storage device of the controller 400 stores a table that shows the relationship between the power consumption of the sub-evacuation pump 520 and the vacuum degree inside the pre-evacuation chamber 232. The controller 400 acquires information on the power consumption of the sub-evacuation pump 520, refers to the table stored in the storage device, and calculates the vacuum degree inside the pre-evacuation chamber 232 using the acquired information on the power consumption. The controller 400 compares the calculated vacuum degree with the vacuum degree at which a main evacuation pump 510 is enabled to perform evacuation to determine whether the vacuum degree inside the pre-evacuation chamber 232 has reached the first vacuum degree.

Note that the storage device of the controller 400 may store the value of the power consumption of the sub-evacuation pump 520 corresponding to the first vacuum degree. In this case, the controller 400 may compare the acquired information on the power consumption with the power consumption value of the sub-evacuation pump 520 stored in the storage device to determine whether the vacuum degree inside the pre-evacuation chamber 232 has reached the first vacuum degree. In other words, the controller 400 determines that the vacuum degree inside the pre-evacuation chamber 232 has reached the first vacuum degree when the power consumption of the sub-evacuation pump 520 reaches the power consumption of the sub-evacuation pump 520 corresponding to the first vacuum degree.

### 2.2.3. Operation of Vacuum Pumping System during Examination

The control process of the vacuum pumping system 500 during examination is the same as the above control process illustrated in FIG. 7, and its description will be omitted.

### 2.2.4. Operation of Vacuum Pumping System during Non-Examination

The relationship between the vacuum degree inside the pre-evacuation chamber 232 and the power consumption of the sub-evacuation pump 520 varies depending on the temperature of the sub-evacuation pump 520. Therefore, in the second embodiment, the sub-evacuation pump 520 operates at specified time intervals, thereby maintaining the temperature of the sub-evacuation pump 520 within a temperature range where the relationship between the vacuum degree inside the pre-evacuation chamber 232 and the power consumption of the sub-evacuation pump 520 remains changed. As a result, in the process of step S204, the controller 400 is capable of determining whether the vacuum degree inside the pre-evacuation chamber 232 has reached a first vacuum degree, based on the power of the sub-evacuation pump 520 without considering the temperature of the sub-evacuation pump 520.

Furthermore, an evacuation port 516 of the main evacuation pump 510 is evacuated at specified time intervals, thereby preventing the backing pressure of the main evacuation pump 510 from reaching the critical backing pressure during the replacement of the sample S. In the transmission electron microscope 2, when the backing pressure of the main evacuation pump 510 reaches the critical backing pressure, the sub-evacuation pump 520 evacuates the evacuation port 516 of the main evacuation pump 510. Accordingly, in this case, the replacement of the sample S is not possible until the backing pressure of the main evacuation pump 510 becomes less than or equal to a threshold, leading to standby time. By evacuating the evacuation port 516 of the main evacuation pump 510 at specified time intervals, it is possible to eliminate this standby time.

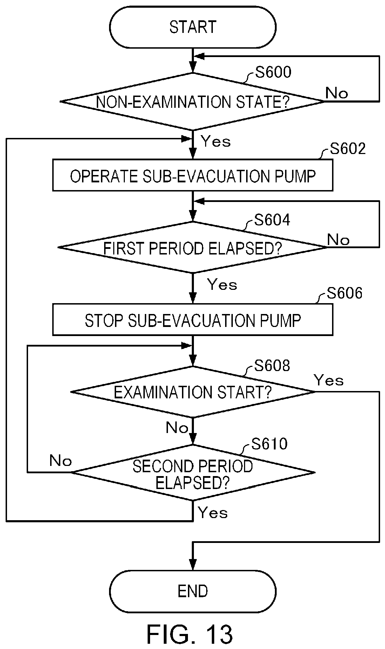

FIG. 13 is a flowchart illustrating an example of the control process of the vacuum pumping system 500 during non-examination. Here, in an initial state during non-examination, the sample chamber 202 is evacuated by the main evacuation pump 510. Hereinafter, the point different from the above point of the control process illustrated in FIG. 9 will be described, and the description of the same point will be omitted.

The controller 400 determines whether the vacuum pumping system 500 is in a non-examination state (step S600). When it is determined that the vacuum pumping system 500 is in the non-examination state (Yes in step S600), the controller 400 operates the sub-evacuation pump 520, opens a fourth valve 534, and causes the sub-evacuation pump 520 to evacuate the evacuation port 516 of the main evacuation pump 510 (step S602). As a result, the sample chamber 202 is evacuated by the main evacuation pump 510, and the evacuation port 516 of the main evacuation pump 510 is evacuated by the sub-evacuation pump 520.

The controller 400 determines whether a first period of time has elapsed since the operation of the sub-evacuation pump 520 (step S604). When it is determined that the first period of time has not elapsed (No in step S604), the controller 400 repeatedly performs the process in step S604.

When it is determined that the first period of time has elapsed since the operation of the sub-evacuation pump 520 (Yes in step S604), the controller 400 closes the fourth valve 534 to stop the sub-evacuation pump 520.

Next, the controller 400 determines whether examination has started (step S608). When it is determined that the examination has started (Yes in step S608), the controller 400 ends the process.

When it is determined that the examination has not started (No in step S608), the controller 400 determines whether a second period of time has elapsed since the stop of the sub-evacuation pump 520 (step S610). When it is determined that the second period of time has not elapsed (No in step S610), the controller 400 returns to the process in step S608.

When it is determined that the second period of time has elapsed (Yes in step S610), the controller 400 returns to the process in step S602. In other words, the controller 400 operates the sub-evacuation pump 520, opens the fourth valve 534, and causes the sub-evacuation pump 520 to evacuate the evacuation port 516 of the main evacuation pump 510 (step S602).

The controller 400 repeatedly performs the processes in steps S602, S604, S606, S608, and S610 until it is determined that the examination has started.

The second period of time in step S610 is set to, for example, approximately 25 minutes. Furthermore, the first period of time in step S604 is set to, for example, approximately five minutes. In other words, the sub-evacuation pump 520 repeatedly performs the process of stopping for 25 minutes and operating for five minutes. As a result, it is possible to maintain the temperature of the sub-evacuation pump 520 within a temperature range where the relationship between the vacuum degree inside the pre-evacuation chamber 232 and the power consumption of the sub-evacuation pump 520 remains unchanged.

Note that the time during which the backing pressure of the main evacuation pump 510 reaches the critical backing pressure is longer than the time during which the temperature of the sub-evacuation pump 520 is maintained within a temperature range where the relationship between the vacuum degree inside the pre-evacuation chamber 232 and the power consumption of the sub-evacuation pump 520 remains unchanged. As described above, in the transmission electron microscope 2, the time during which the backing pressure of the main evacuation pump 510 reaches the critical backing pressure is, for example, approximately 30 hours. Therefore, by setting the first period of time and the second period of time to values that maintain the temperature of the sub-evacuation pump 520 within a temperature range where the relationship between the vacuum degree inside the pre-evacuation chamber 232 and the power consumption of the sub-evacuation pump 520 remains unchanged, it is possible to prevent the backing pressure of the main evacuation pump 510 from reaching the critical backing pressure.

### 2.3. Effects

In the transmission electron microscope 2 according to the second embodiment, when the sample S is illuminated with an electron beam, the controller 400 performs: the process of causing the main evacuation pump 510 to evacuate the sample chamber 202; the process of determining whether the backing pressure of the main evacuation pump 510 is greater than a first pressure based on the power of the main evacuation pump 510; the process of causing the sub-evacuation pump 520 to evacuate the evacuation port 516 when it is determined that the backing pressure of the main evacuation pump 510 is greater than the first pressure; the process of determining whether the backing pressure of the main evacuation pump 510 is less than or equal to a second pressure based on the power of the main evacuation pump 510; and the process of stopping the sub-evacuation pump 520 when it is determined that the backing pressure of the main evacuation pump 510 is less than or equal to the second pressure. As described above, the sub-evacuation pump 520 operates intermittently in the transmission electron microscope 2. Therefore, it is possible to extend the life span of the sub-evacuation pump 520. Moreover, in the transmission electron microscope 2, the backing pressure of the main evacuation pump 510 is determined from the power of the main evacuation pump 510. Therefore, for example, a vacuum gauge to measure the backing pressure of the main evacuation pump 510 is not required. Accordingly, it is possible to reduce the number of components in the transmission electron microscope 2.

In the transmission electron microscope 2 according to the second embodiment, when the sample S is not illuminated with an electron beam, the controller 400 performs: the process of causing the main evacuation pump 510 to evacuate the sample chamber 202; and the process of repeatedly performing the process of operating the sub-evacuation pump 520 for a first period of time to evacuate, by the sub-evacuation pump 520, the evacuation port 516 and the process of stopping the sub-evacuation pump 520 for a second period of time.

Therefore, in the transmission electron microscope 2 according to the second embodiment, it is possible to maintain, during examination, the temperature of the sub-evacuation pump 520 within a temperature range where the relationship between the vacuum degree inside the pre-evacuation chamber 232 and the power consumption of the sub-evacuation pump 520 remains unchanged. Accordingly, during pre-evacuation for introducing the sample S from the pre-evacuation chamber 232 into the sample chamber 202, it is possible to determine the vacuum degree inside the pre-evacuation chamber 232 from the power consumption of the sub-evacuation pump 520. Moreover, a temperature gauge to measure the temperature of the sub-evacuation pump 520 is not required.

### 3. Modified Examples

### 3.1. First Modified Example

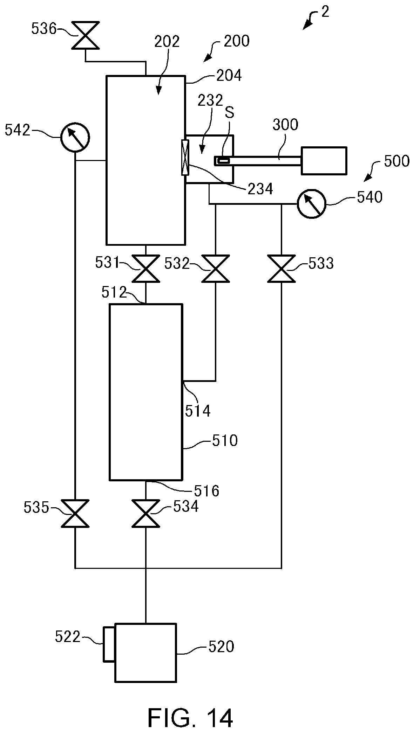

FIG. 14 is a diagram illustrating a modified example of the configuration of the vacuum pumping system 500. As illustrated in FIG. 14, the transmission electron microscope 2 may have a vacuum gauge 540 to measure the vacuum degree inside the pre-evacuation chamber 232 and a vacuum gauge 542 to measure the vacuum degree inside the sample chamber 202. The vacuum gauge 540 is provided between the pre-evacuation chamber 232 and the third valve 533. The vacuum gauge 540 is also capable of measuring the backing pressure of the main evacuation pump 510. The vacuum gauge 542 is provided between the sample chamber 202 and the fifth valve 535.

In the transmission electron microscope 2 including the vacuum pumping system 500 illustrated in FIG. 14, for example, information on the vacuum degree inside the sample chamber 202 may be acquired from the vacuum gauge 542 in the process of step S104 in FIG. 5. Furthermore, in the processes of steps S204 and S208 illustrated in FIG. 6, information on the vacuum degree inside the pre-evacuation chamber 232 may be acquired from the vacuum gauge 540. Furthermore, in the processes of steps S406 and S410 illustrated in FIG. 7, the backing pressure of the main evacuation pump 510 may be acquired from the vacuum gauge 540.

### 3.2. Second Modified Example

In the above first and second embodiments, the main evacuation pump 510 is a turbo molecular pump. However, the main evacuation pump 510 is not limited to a turbo molecular pump. For example, the main evacuation pump 510 may also be an oil diffusion pump (DP). Furthermore, in the above first and second embodiments, the sub-evacuation pump 520 is a diaphragm pump. However, the sub-evacuation pump 520 is not limited to a diaphragm pump. For example, the sub-evacuation pump 520 may also be a mechanical booster pump, a root pump, or a rotary pump.

### 3.3. Third Modified Example

For example, in the above first and second embodiments, the charged particle beam system according to the invention is a transmission electron microscope. However, the charged particle beam system according to the invention is not limited to a transmission electron microscope but may also be, for example, a scanning electron microscope or a focused ion beam system. In other words, the charged particle beam system according to the invention only needs to include a charged particle source that generates charged particle beams such as electron beams or ion beams, and to illuminate a sample with the charged particle beams.

Note that the above embodiments and modified examples are examples and the invention is not limited thereto. For example, the embodiments and modified examples may be combined as appropriate.

The invention is not limited to the above-described embodiments, and various modifications can be made. For example, the invention includes configurations that are substantially the same as the configurations described in the embodiments. Substantially same configurations mean configurations having the same functions, and methods, for example. The invention also includes configurations obtained by replacing non-essential elements of the configurations described in the embodiments with other elements. The invention further includes configurations obtained by adding known art to the configurations described in the embodiments.

## Claims

1. A charged particle beam system that illuminates a sample with a charged particle beam, the charged particle beam system comprising:
a sample chamber in which a sample is placed;
a pre-evacuation chamber that is connected to the sample chamber via a partition valve;
a first evacuation pump that has a first port, a second port, and an evacuation port, the first port being connected to the sample chamber, and the second port being connected to the pre-evacuation chamber;
a second evacuation pump that is connected to the pre-evacuation chamber, the evacuation port, and the sample chamber; and
a controller that controls the first evacuation pump and the second evacuation pump,
the controller performing, when a sample is introduced into the pre-evacuation chamber:
a process of causing the second evacuation pump to evacuate the pre-evacuation chamber;
a process of making a determination of whether a vacuum degree inside the pre-evacuation chamber has reached a first vacuum degree, based on power of the second evacuation pump; and
a process of causing the first evacuation pump to evacuate the pre-evacuation chamber when the vacuum degree inside the pre-evacuation chamber is determined to have reached the first vacuum degree.

2. The charged particle beam system according to claim 1, further comprising:
a temperature gauge that measures a temperature of the second evacuation pump, wherein
in the process of making a determination of whether the vacuum degree inside the pre-evacuation chamber has reached the first vacuum degree, the controller performs the process of making the determination based on the power and the temperature of the second evacuation pump.

3. The charged particle beam system according to claims 1 and 2, wherein
the controller performs,
after the process of causing the first evacuation pump to evacuate the pre-evacuation chamber, a process of determining whether the vacuum degree inside the pre-evacuation chamber has reached a second vacuum degree, based on power of the first vacuum evacuation pump, and
when the vacuum degree inside the pre-evacuation chamber is determined to have reached the second vacuum degree, a process of notifying that a sample can be introduced into the sample chamber.

4. The charged particle beam system according to any one of claims 1 to 3, wherein the controller performs
a process of causing the first evacuation pump to evacuate the sample chamber,
a process of determining whether a backing pressure of the first evacuation pump is greater than a first pressure, based on the power of the first evacuation pump,
a process of causing the second evacuation pump to evacuate the evacuation port when the backing pressure of the first evacuation pump is determined to be greater than the first pressure,
a process of determining whether the backing pressure of the first evacuation pump is less than or equal to a second pressure, based on the power of the first evacuation pump, and
a process of stopping the second evacuation pump when the backing pressure of the first evacuation pump is determined to be less than or equal to the second pressure.

5. The charged particle beam system according to any one of claims 1 to 3, wherein when a sample is illuminated with a charged particle beam,
the controller performs
a process of causing the first evacuation pump to evacuate the sample chamber,
a process of determining whether a backing pressure of the first evacuation pump is greater than a first pressure, based on the power of the first evacuation pump,
a process of causing the second evacuation pump to evacuate the evacuation port when the backing pressure of the first evacuation pump is determined to be greater than the first pressure,
a process of determining whether the backing pressure of the first evacuation pump is less than or equal to a second pressure, based on the power of the first evacuation pump, and
a process of stopping the second evacuation pump when the backing pressure of the first evacuation pump is determined to be less than or equal to the second pressure.

6. The charged particle beam system according to claim 5, wherein
when a sample is not illuminated with a charged particle beam,
the controller performs
the process of causing the first evacuation pump to evacuate the sample chamber, and
a process of repeatedly operating the second evacuation pump for a first period of time to evacuate the evacuation port and stopping the second evacuation pump for a second period of time.

7. The charged particle beam system according to any one of claims 1 to 6, further comprising:
a charged particle source that generates a charged particle beam, wherein
the sample chamber and a space in which the charged particle source is placed communicate with each other.

8. A method of controlling a charged particle beam system that includes a sample chamber in which a sample is placed,
a pre-evacuation chamber that is connected to the sample chamber via a partition valve,
a first evacuation pump that has a first port, a second port, and an evacuation port, the first port being connected to the sample chamber, and the second port being connected to the pre-evacuation chamber, and
a second evacuation pump that is connected to the pre-evacuation chamber, the evacuation port, and the sample chamber,
the method comprising:
causing the second evacuation pump to evacuate the pre-evacuation chamber when a sample is introduced into the pre-evacuation chamber;
determining whether a vacuum degree inside the pre-evacuation chamber has reached a first vacuum degree, based on power of the second evacuation pump; and
causing the first evacuation pump to evacuate the pre-evacuation chamber when the vacuum degree inside the pre-evacuation chamber is determined to have reached the first vacuum degree.
